# EUROPEAN PATENT SPECIFICATION

(11) **EP 0 854 828 B1**
(45) Date of publication and mention of the grant of the patent: **19.09.2001**
(21) Application number: 95935678.3
(22) Date of filing: 13.10.1995
(51) Int. Cl.: B65D 85/48

(54) **SHIPPING AND TRANSPORT CASSETTE WITH KINEMATIC COUPLING**
VERSAND UND TRANSPORTKASSETTE MIT EINER KINEMATISCHEN KUPPLUNG
CASSETTE DE TRANSPORT ET D'EXPEDITION A COUPLAGE CINEMATIQUE

(43) Date of publication of application: 29.07.1998
(73) Proprietor: Empak, Inc., Chanhassen, MN 55317 (US)
(72) Inventor: PETERSON, Kelly, Savage, MN 55378 (US); WISEMAN, Brian, Colorado Springs, CO 80918 (US); GALLAGHER, Gary, Colorado Springs, CO 80906 (US); GREGERSON, Barry, Deephaven, MN 55331 (US)
(74) Representative: MacGregor, Gordon
(86) International application number: US9512515
(87) International publication number: WO9713709

(56) References cited:
- US-A- 4 588 086
- US-A- 4 817 795
- US-A- 5 111 936

## Description

### I. Field of the Invention

The present invention relates to a cassette used for shipping and transporting various items. More specifically, the invention relates to cassettes specifically designed for holding wafers, rigid memory disks, flat panel displays, liquid crystal displays, or photomasks. The invention is particularly advantageous when used to hold relatively large items such as wafers having, for example, a diameter of 300mm or more. However, cassettes made in accordance with the invention can also be used to hold smaller items.

### II. Description of the Prior Art

Various containers have been used in the prior art to - hold silicon wafers, rigid memory disks, flat panel displays, liquid crystal displays and the like. Such items must be protected as they are transported from point to point within a manufacturing facility because they tend to be very fragile. Loading such items into cassettes for transport has proven to be an effective means of providing protection.

Early cassettes were heavy, bulky and expensive. These early cassettes also were not well adapted to the environment in which they had to function. The heat and harsh chemicals used in such environments often weakened such prior art cassettes causing them to bend, flex, warp or even break during processing. Such damage to the cassette would often destroy the items stored in the cassette.

Later cassette designs sought to overcome the disadvantages of the prior art by providing various gussets, supports or H-bars to reinforce the cassette to prevent such warpage. Also, materials such as Teflon® were used. These materials were selected to withstand chemical etching processes to which the items are routinely subjected. Such techniques were adequate for cassettes designed to hold smaller items such as those having a length or diameter of approximately 150mm or less. However, given recent trends in the semiconductor and electronics industry, new cassette designs are needed which can accommodate items of a larger size. Such cassettes must be designed so that they will not flex, warp, bend or break, even when subjected to high temperatures or harsh chemicals. Further, given the size and weight of such items, robotic handling becomes more and more important thereby requiring structures on the cassette which can assist in indexing and positioning the cassette with respect to processing equipment.

### SUMMARY OF THE INVENTION

The present invention provides cassettes as defined in claim 1.

The present invention is directed toward cassettes specifically designed to accommodate large diameter wafers (*i*.*e*., those having a diameter of 300mm or more) and other items similar in size. Such cassettes can be used to hold smaller items as well. Unique reinforcement structures are provided which prevent warpage, bending, flexing or breaking of the cassette while in use. These reinforcements structures are designed in such a way that the amount of material used to make the cassette is reduced, thereby reducing cost and weight.

The present invention also provides cassettes which are easily cleaned. Such cassettes are able to hold the items in spaced apart, parallel orientation so that the items do not come in contact with each other, causing damage. The cassettes also include a set of grooves used to kinematically couple the cassettes to equipment used in the processing or handling of the items. These kinematic grooves can be used, for example, to register the cassette inside a microenvironment pod to help protect the items during shipping and transport.

In view of the foregoing, one object of the invention is to provide a cassette which is able to hold, for example, a plurality of wafers, each wafer having a diameter of 300mm or more.

Another object of the invention is to provide a cassette having suitable reinforcements, given its size, to prevent warpage, bending, flexing or breaking of the cassette even when the cassette is subjected to harsh chemicals or high temperatures.

Still a further object of the invention is to provide a cassette capable of holding a plurality of items in a spaced apart, parallel orientation with respect to each other.

Still another object of the invention is provide such a cassette which includes a kinematic coupling so that the cassette can be aligned with processing equipment or appropriately positioned in a microenvironment pod.

Still another object of the invention is to provide such a cassette which has an open top and open bottom.

Still another object of the invention is to provide such a cassette wherein all surfaces of the cassette are easily cleaned and decontaminated.

These and other objects of the invention will become more apparent from the reading of the detailed description of the preferred embodiment set forth below in conjunction with the drawings all of which form part of this specification.

### BRIEF DESCRIPTION OF THE DRAWINGS

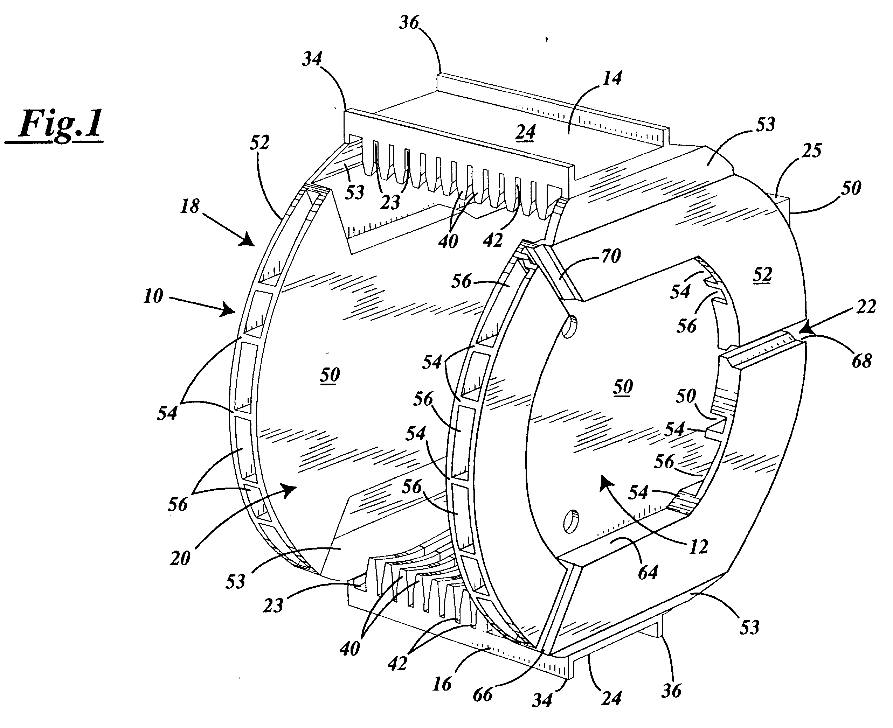

Figure 1 is a perspective view of a cassette incorporating the features of the present invention;

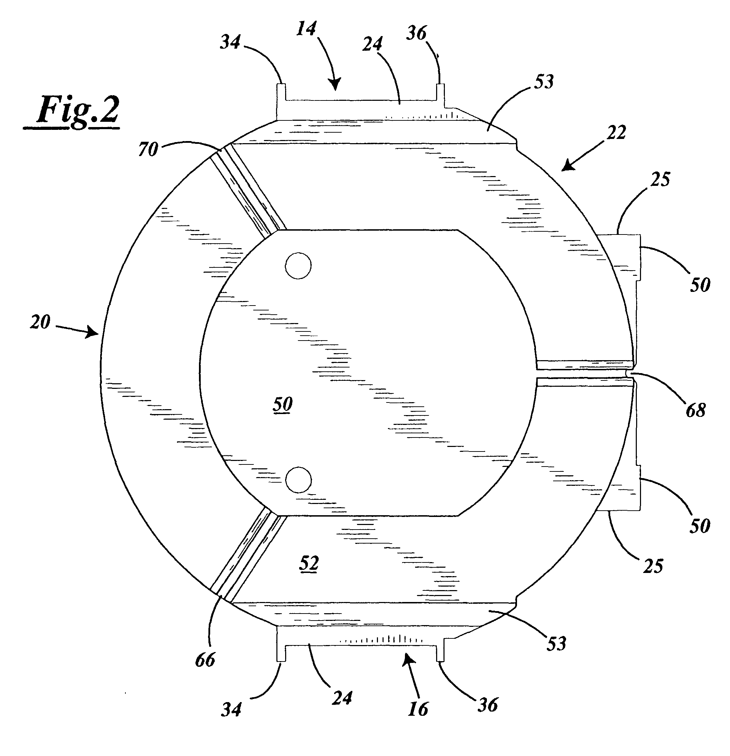

Figure 2 is an elevational view of one of the ends of the cassette of the present invention;

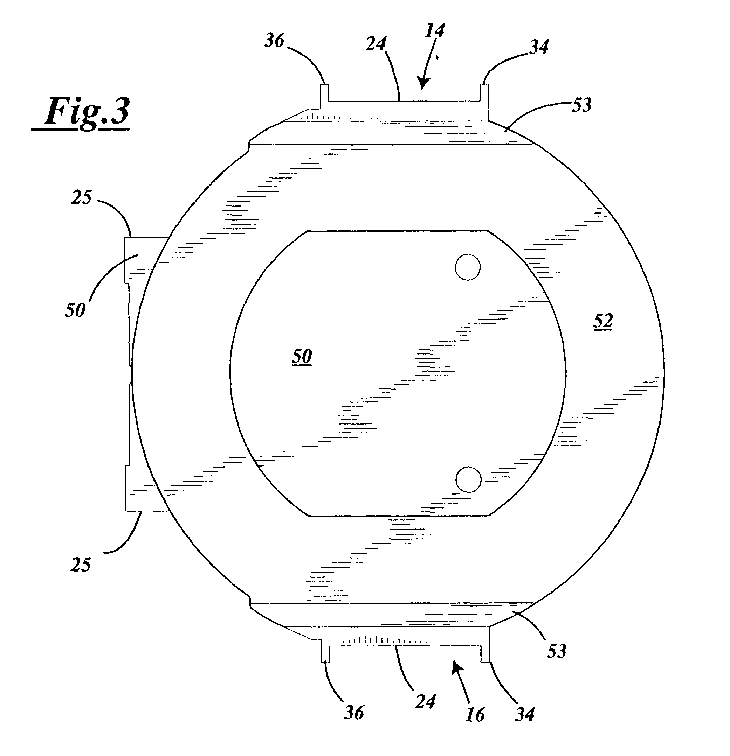

Figure 3 is an elevational view of the end of the cassette opposite that shown in Figure 2;

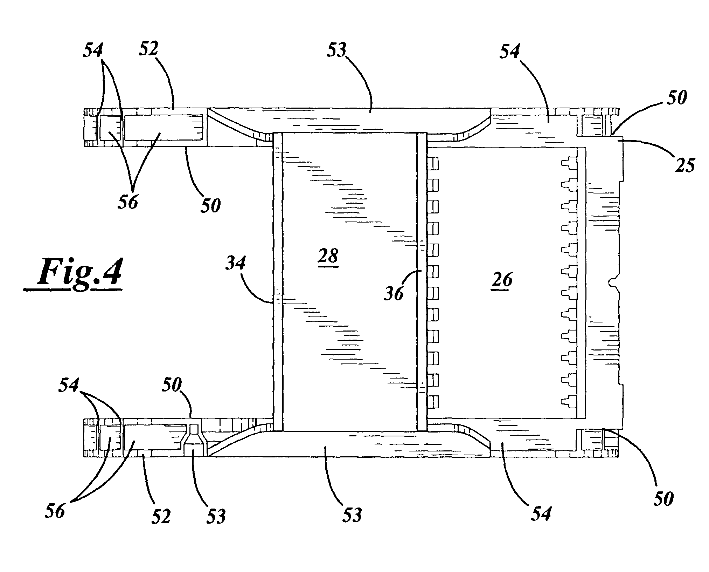

Figure 4 is an elevational view of one side of the cassette;

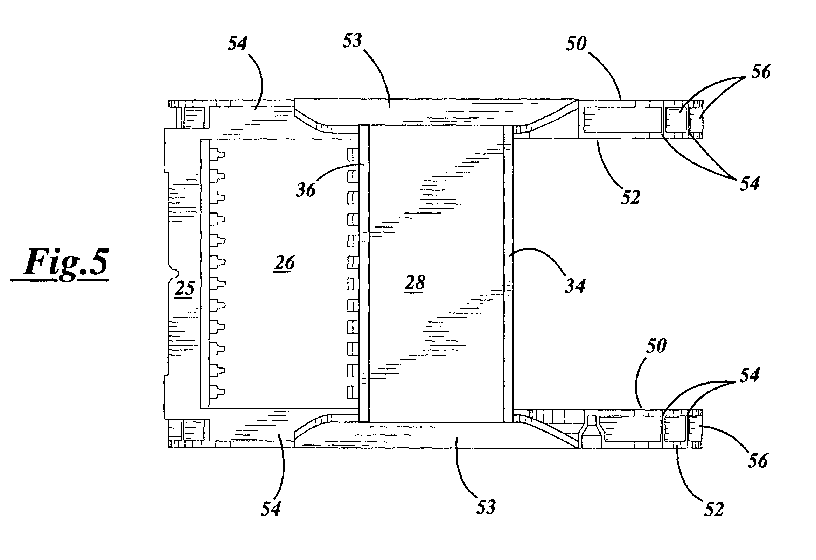

Figure 5 is an elevational view of the side of the cassette opposite that shown in Figure 4;

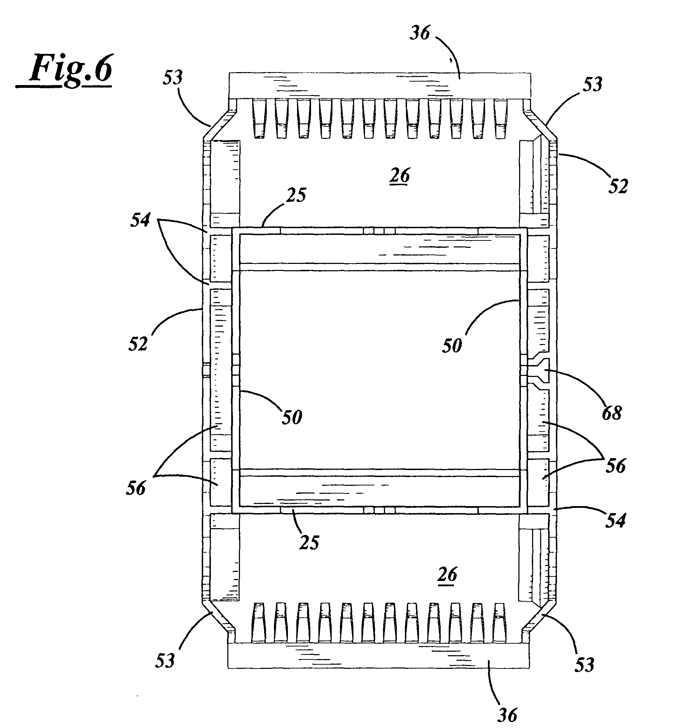

Figure 6 is a bottom plan view of the cassette;
Figure 7 is a top plan view of the cassette; and
Figure 8 is a cross section showing two opposing dividers and a wafer.

### DESCRIPTION OF THE PREFERRED EMBODIMENT

As indicated above, the present invention provides cassettes which can hold items such as silicon wafers, rigid memory disks, flat panel displays, liquid crystal displays, and photomasks, substrates, or the like. So that it is not necessary to continually repeat this entire list, the drawings and description set forth below are provided in terms of a "wafer" cassette. Those skilled in the art should recognize that the benefits of the invention apply equally to all such items and that there is no intention that this in any way be limiting. The various components of the cassette should be constructed of materials with low outgassing characteristics which are durable and exhibit little, if any, particulation.

The wafer cassette 10 of the preferred embodiment includes a first open side 20, a second open side 22, a first end wall 12, a pair of opposing side walls 14 and 16, and a second end wall 18. The first open side 20 is large enough to permit wafers to be inserted into or removed from the cassette 10. The second open side 22 is small enough so that the wafers are supported within the cassette 10, but large enough to let liquid chemicals readily pass through the cassette 10 between any wafers stored within the cassette.

The two side walls 14 and 16 are the mirror image of each other. Each side wall has an interior surface 23, and an exterior surface 24, a lower member 25, an intermediate-member 26, and an upper member 28. Members 25, 26 and 28 of each sidewall are integrally formed so that the top of intermediate member 26 is at a position above and outside the top of lower member 25. The upper member 28 projects upwardly from the top of the intermediate member 26. Projecting outwardly from the planar outer surface 24 of the upper member 28 are an upper reinforcing rail 34 and a lower reinforcing rail 36. Rails 34 and 36 help support the cassette 10 and also provide a means by which a robotic arm can effectively grip and hold the cassette.

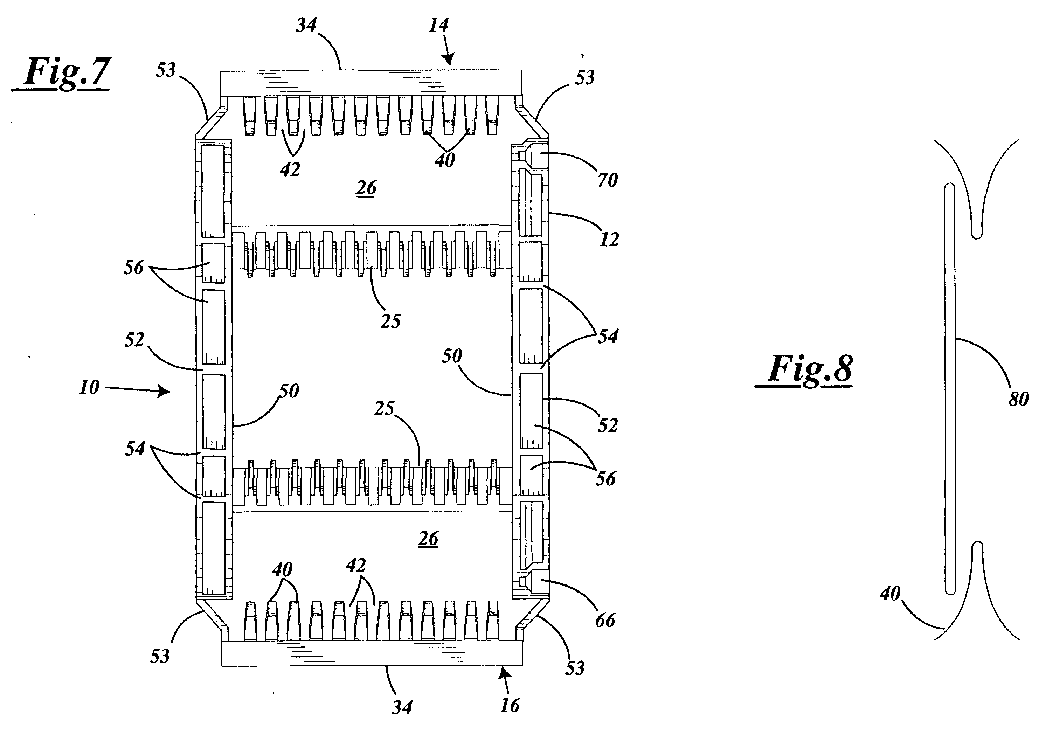

The cassette 10 also includes a plurality of dividers 40 on the interior surface 23 of each side wall 14 and 16. The dividers 40 generally extend from the top of upper member 28 to the bottom of intermediate member 26. The dividers 40 on side wall 14 oppose those on side wall 16. The dividers 40 serve to hold each wafer in a parallel, spaced apart, non-contacting relationship with respect to the other wafers stored in the cassette. The dividers 40, in the longitudinal direction, have a radius of curvature mirroring that of the wafer. The dividers 40 are also tapered in the transverse direction to reduce the likelihood of damage to the wafers as the wafers are placed into or removed from the cassette 10. More specifically as shown in Figure 8, the dividers 40 have a continuously varying slope which is used to center the wafer in the middle of the carrier when the wafers are oriented in a horizontal direction. The slope may range from vertical at the wall to completely horizontal at the very edge of the divider. Given this configuration, the wafer should always rest on a portion of the divider that has a finite slope, so edge contact is guaranteed. When the wafers 80 are transported horizontally, gravity helps center the wafers 80 given the configuration of these dividers 40. Once centered, the wafer's vertical location is precisely defined. Further, as the container is moved from one location to the next, small levels of vibration help center the wafer in the container. This assists in improving horizontal positional accuracy of the wafers as well as the vertical positional accuracy.

Additional benefits are provided by this divider design. For example, it presents the lowest possible cross section for a given strength. The dividers 40 present an area of interference for the wafer as it is inserted and removed from the carrier, thus, thin supports are preferred because there is less chance of the wafer 80 hitting the divider 40 and causing particles to be generated. Also, the dividers are strong enough to support the wafer and to avoid deflection over the life of the container.

Between each pair of dividers 40 is a wafer receiving groove 42. At least a portion of the back side of the groove 42 has a radius of curvature in the longitudinal direction which is generally the same as the radius of curvature of the wafer around the wafer's circumference. The configuration is advantageous because the wafer is supported by the groove 42 along a line rather than at a single point. Such support improves stability of the wafers within the cassette. Such support also aids in ensuring that the wafers are completely horizontal when the cassette 10 is docked to a wafer transfer tool. The side walls 14 and 16 of the cassette 10 are spaced from each other a distance suitable for receiving and storing wafers of a particular diameter, for example, 300mm. The cassette can be sized to hold any number of wafers. Two typical configurations would be thirteen and twenty-five capacity cassettes. The number of dividers 40 changes depending on the capacity of the cassette.

The dividers 40 and grooves 42 are preferably oriented to achieve certain advantages. First, they are oriented to hold the wafers at a predetermined pitch in the range of 5mm to 12mm. Second, they are oriented to provide a clearance of 3mm to 8mm between wafers. Third, a clearance of 1mm to 3mm is provided between each of the side walls 14 and 16 of the cassette 10 and the edges of the wafers at the diameter of the wafer parallel to the plane of the open sides 20 and 22. Providing such a pitch and these clearances ensures that the wafers do not touch each other in the cassette. Also, these clearances are sufficient to permit robotic insertion and removal of wafers when the cassette is docked to the wafer transfer tool.

Several unique features of the design reside in the construction of first end wall 12. The first end wall 12 consists of a first plate 50, a second plate 52 and a plurality of bridging members 54 separated by channels 56. Plates 50 and 52 are securely held apart and parallel to each other by the bridging members 54 Each of the channels 56 are formed by a portion of the first plate 50, a portion of the second plate 52, and two of the bridging members 54. The channels 56 each have an open top 58 and an open bottom 60 so fluids can readily pass through the channels 56 during processing of wafers or cleaning of the cassette. There are no closed corners or the like in the channels which are difficult to clean or where fluid can collect or be trapped during cleaning of the cassette 10 or processing of the wafers.

Plate 50 is generally flat. Plate 52 is also generally flat, but has a large opening 64 in the center. Formed in the face of second plate 52 and extending back to the first plate 50 are three kinematic coupling grooves - 66, 68 and 70. These grooves can be used to index the cassette to another object, such as the port of wafer processing equipment. The grooves 66, 68 and 70 cooperate with three complementary projections on the object designed to mate with the grooves 66, 68 and 70 to achieve proper alignment of the cassette 10. Those skilled in the art will recognize that alternative arrangements exist for providing the kinematic grooves 66, 68 and 70. For example, the grooves could be molded into a separate block which is then attached to plate 52 with screws, pins, or an ultrasonic weld, or an adhesive bond.

Many of the advantages are derived from a front wall 12 having this design. First, the combination of the two plates 50 and 52 and bringing members 54 reduces warpage or bending of the walls. Second, the design is very easy to clean and is readily capable of draining fluids during processing of wafers. This is because the channels 56 have an open top and bottom. There are no spaces which are blocked in such a way as to cause fluids to collect in the cassette 10. Third, the kinematic coupling grooves 66, 68 and 70, when mated with complementary projections on a surface, simplify positioning of the cassette 10 on the surface. Fourth, less plastic is required and the overall design is lighter. Fifth, the cassette 10 can be easily gripped by the human hand or robotic tool because of the opening 64 in plate 52. The cassette 10 can also be gripped from the sides by a robotic tool because of the reinforcing rails 34 and 36.

The design of the first wall 12 results in a unique way of joining it to the two side walls 14 and 16. Opposite side edges of the lower portion of first plate 50 are joined at approximately a right angle with the lower member 25 of each of the opposing side walls 14 and 16. Opposite edged of plate 52 are also joined to the upper member 28 of each of the side walls 14 and 16. This is achieved by providing angled panels 53 between the plate 52 and upper members 28 of the side walls. The panels 53, - being angled with respect to both plate 52 and upper member 28, assist in strengthening the overall design.

The second wall 18 of the cassette 10 can have the identical design as the first end wall 12. However, it is generally not necessary for both the first and second end walls to have the kinematic coupling grooves such as 66, 68 and 70. Thus, such grooves are not shown on the second end wall 18 in the drawings.

As set forth above, the present invention offers many advantages which are not limited to the storage and transfer of silicon wafers. This same invention can successfully be used to store and transfer rigid memory disks, photomasks, liquid crystal displays, flat panel displays, substrates, and the like. Various modifications and additions can be made to the cassette disclosed herein and may be made without departing from the invention which is intended to be defined by the claims set forth below.

## Claims

1. A cassette for holding a plurality of items comprising:
(a) a first open side (20);
(b) a second open side (22);
(c) a first side wall (14) and a second side wall (16), each of said side walls having an interior surface (23) and a plurality of dividers (40) extending inwardly from said interior surface (23), said first and second side walls cooperating to support a plurality of items within the cassette so that each item supported by said first and second side walls (14,16) is in a parallel, spaced apart, non-contacting relationship with respect to each of the other of said plurality of items;
(d) a first end wall (12) and a second end wall (18) each integrally formed with said side walls, said first end wall having:
(i) a first plate (50);
(ii) a second plate (52);
(iii) a plurality of bridging members (54) designed to securely hold said first plate and said second plate apart and parallel to each other; and
(iv) a plurality of channels (56), each channel formed by a portion of said first plate (50), a portion of said second plate (52) and a pair of said plurality of bridging members (54) each channel having an open top (58) and an open bottom (60) so that fluids can readily pass through said channel and not become trapped therein.

2. The cassette of claim 1 wherein said second plate has a large central opening (64).

3. The cassette of claim 1 further including a first set of at least three grooves (66, 68, 70) for kinematically positioning the cassette with respect to another object.

4. The cassette of claim 1 wherein said second end wall (18) also has:
(a) a first plate;
(b) a second plate;
(c) a plurality of bridging members designed to securely hold said first plate and said second plate apart and parallel to each other; and
(d) a plurality of channels, each channel formed by a portion of said first plate, a portion of said second plate, and a pair of said plurality of bridging members, each channel having an open top and an open bottom so that fluids can readily pass through said channel and not become trapped therein.

5. The cassette of claim 4 wherein said second plate of said first end wall and said second plate of said second end wall each have a large central opening.

6. The cassette of claim 3 further including a second set of at least three grooves, either said first set or said second set capable of being used to kinematically position the cassette with respect to another object.

7. The cassette of claim 1 wherein each of said side walls have a lower member (25), an intermediate member (26) and an upper member (28).

8. The cassette of claim 7 wherein the upper member (28) of each side wall has a pair of outwardly projecting rails.

9. The cassette of claim 7 wherein the lower member of each of said side walls (14,16) is directly attached to the first plate of each of said end walls (12,18).

10. The cassette of claim 7 wherein separate panels (53) are provided at opposite ends of the upper member of each side wall for attaching the upper member (28) of each side wall (14,16) to the second plate of each of end wall (12,18).

11. The cassette of claim 1 wherein item-receiving grooves are formed by pairs of said plurality of dividers (40), a portion of the backside of each groove having a radius of curvature in the longitudinal direction of the groove which is generally the same as the radius of curvature of the items held within the cassette around the circumference of the items.

12. The cassette of claim 1 wherein at least some of said dividers (40) have in cross-section a continuously varying slope to help support a wafer.

## Patentansprüche

1. Kassette zum Halten mehrerer Gegenstände, mit:
(a) einer ersten offenen Seite (20),
(b) einer zweiten offenen Seite (22),
(c) einer ersten Seitenwand (14) und einer zweiten Seitenwand (16), wobei jede der Seitenwände eine innere Oberfläche (23) und mehrere sich von der inneren Oberfläche (23) nach innen erstreckende Unterteiler (40) aufweist und die ersten und zweiten Seitenwände zusammenwirken, um mehrere Gegenstände in der Kassette so zu haltern, daß sich jeder der von den ersten und zweiten Seitenwänden (14,16) gehalterten Gegenstände in einer parallelen, beabstandeten, nicht-berührenden Beziehung in bezug auf jeden anderen der mehreren Gegenstände befindet,
(d) einer ersten Endwand (12) und einer zweiten Endwand (18), die jeweils einstückig mit den Seitenwänden ausgebildet sind, wobei die erste Endwand aufweist:
(i) eine erste Platte (50),
(ii) eine zweite Platte (52),
(iii) mehrere Brückenelemente (54), die so gestaltet sind, daß sie die erste Platte und die zweite Platte sicher auseinander und parallel zueinander halten, und
(iv) mehrere Kanäle (56), wobei jeder Kanal durch einen Abschnitt der ersten Platte (50), einen Abschnitt der zweiten Platte (52) und ein Paar der mehreren Brückenelemente (54) gebildet ist, wobei jeder Kanal eine offene Oberseite (58) und eine offene Unterseite (60) aufweist, so daß Fluide den Kanal leicht passieren können und nicht darin eingeschlossen werden.

2. Kassette nach Anspruch 1, wobei die zweite Platte eine große zentrale Öffnung (64) aufweist.

3. Kassette nach Anspruch 1, ferner mit einem ersten Satz von mindestens drei Nuten bzw. Rillen (66,68,70) zum kinematischen Positionieren der Kassette in bezug auf ein anderes Objekt.

4. Kassette nach Anspruch 1, wobei die zweite Endwand (18) ebenfalls aufweist:
(a) eine erste Platte,
(b) eine zweite Platte,
(c) mehrere Überbrückungselemente, die so gestaltet sind, daß sie die erste Platte und die zweite Platte sicher auseinander und parallel zueinander halten, und
(d) mehrere Kanäle, wobei jeder Kanal durch einen Abschnitt der ersten Platte, einen Abschnitt der zweiten Platte und ein Paar der mehreren Überbrückungselemente gebildet ist, wobei jeder Kanal eine offene Oberseite und eine offene Unterseite aufweist, so daß Fluide den Kanal leicht passieren können und nicht darin eingeschlossen werden.

5. Kassette nach Anspruch 4, wobei die zweite Platte der ersten Endwand und die zweite Platte der zweiten Endwand jeweils eine große zentrale Öffnung aufweisen.

6. Kassette nach Anspruch 3, ferner mit einem zweiten Satz von mindestens drei Nuten bzw. Rillen, wobei entweder der erste Satz oder der zweite Satz verwendet werden kann, um die Kassette in bezug auf ein anderes Objekt kinematisch zu positionieren.

7. Kassette nach Anspruch 1, wobei jede der Seitenwände ein unteres Element (25), ein Zwischenelement (26) und ein oberes Element (28) aufweist.

8. Kassette nach Anspruch 7, wobei das obere Element (28) jeder Seitenwand ein Paar nach außen vorstehender Schienen aufweist.

9. Kassette nach Anspruch 7, wobei das untere Element jeder der Seitenwände (14,16) direkt an der ersten Platte jeder der Endwände (12,18) befestigt ist.

10. Kassette nach Anspruch 7, wobei separate Platten (53) an gegenüberliegenden Enden des oberen Elements jeder Seitenwand vorgesehen sind, um das obere Element (28) jeder Seitenwand (14,16) an der zweiten Platte jeder der Endwände (12,18) zu befestigen.

11. Kassette nach Anspruch 1, wobei einen Gegenstand aufnehmende Nuten bzw. Rillen durch Paare der mehreren Unterteiler (40) gebildet sind, wobei ein Abschnitt der Rückseite jeder Nut einen Krümmungsradius in der Längsrichtung der Nut aufweist, der im allgemeinen der gleiche ist wie der Krümmungsradius der in der Kassette gehaltenen Gegenstände um den Umfang der Gegenstände.

12. Kassette nach Anspruch 1, wobei mindestens einige der Unterteiler (40) im Querschnitt eine kontinuierlich variierende Abschrägung haben, um einen Wafer haltern zu helfen.

## Revendications

1. Cassette destinée à maintenir une pluralité d'articles, comprenant :
(a) un premier côté ouvert (20) ;
(b) un second côté ouvert (22) ;
(c) une première paroi latérale (14) et une seconde paroi latérale (16), chacune des parois latérales comportant une surface intérieure (23) et une pluralité d'éléments|de compartimentage (40) s'étendant vers l'intérieur à partir de ladite surface intérieure (23), lesdites première et seconde parois latérales coopérant afin de soutenir une pluralité d'articles à l'intérieur de la cassette, de façon telle que chaque article soutenu par lesdites première et seconde parois latérales (14, 16) soit dans une situation de parallélisme et d'espacement, sans contact, par rapport à chacun des autres articles de la pluralité d'articles ;
(d) une première paroi d'extrémité (12) et une seconde paroi d'extrémité (18) formant chacune une seule pièce avec lesdites parois latérales, ladite première paroi d'extrémité comportant :
(i) une première plaque (50) ;
(ii) une seconde plaque (52) ;
(iii) une pluralité d'éléments de liaison (54) conçus de façon à maintenir de façon sûre ladite première plaque et ladite seconde plaque séparées l'une de l'autre et parallèles entre elles ; et
(iv) une pluralité de canaux (56), chaque canal étant constitué par une partie de ladite première plaque (50), par une partie de ladite seconde plaque (52), et par une paire d'éléments de liaison de ladite pluralité d'éléments de liaison (54), chaque canal comportant un sommet ouvert (58) et une base ouverte (60), de façon telle que des fluides peuvent facilement passer dans ledit canal et ne pas s'y trouver piégés.

2. Cassette selon la revendication 1, dans laquelle ladite seconde plaque comporte une grande ouverture centrale (64).

3. Cassette selon la revendication 1 comportant, en outre, un premier jeu d'au moins trois rainures (66, 68, 70) destinées au positionnement cinématique de la cassette par rapport à un autre objet.

4. Cassette selon la revendication 1, dans laquelle ladite seconde paroi d'extrémité (18) comporte également :
(a) une première plaque ;
(b) une seconde plaque ;
(c) une pluralité d'éléments de liaison conçus pour maintenir de façon sûre ladite première plaque et ladite seconde plaque à l'écart l'une de l'autre et parallèles entre elles ; et
(d) une pluralité de canaux, chaque canal étant formé par une partie de ladite première plaque, par une partie de ladite seconde plaque et par une paire d'éléments de liaison de ladite pluralité d'éléments, chaque canal comportant un sommet ouvert et une base ouverte, de façon telle que des fluides peuvent facilement passer dans ledit canal et ne pas s'y trouver piégés.

5. Cassette selon la revendication 4, dans laquelle ladite seconde plaque de ladite première paroi d'extrémité et ladite seconde plaque de ladite seconde paroi d'extrémité comportent chacune une grande ouverture centrale.

6. Cassette selon la revendication 3 comprenant, en outre, un second jeu d'au moins trois rainures, l'un desdits premier jeu et second jeu étant apte à être utilisé pour positionner cinématiquement la cassette par rapport à un autre objet.

7. Cassette selon la revendication 1, dans laquelle chacune desdites parois latérales comporte un élément inférieur (25), un élément intermédiaire (26) et un élément supérieur (28) ;

8. Cassette selon la revendication 7, dans laquelle l'élément supérieur (28) de chaque paroi latérale comporte une paire de rails faisant saillie à l'extérieur.

9. Cassette selon la revendication 7, dans laquelle l'élément inférieur de chacune desdites parois latérales (14, 16) est fixé directement à la première plaque de chacune desdites parois d'extrémité (12, 18).

10. Cassette selon la revendication 7, dans laquelle des panneaux séparés (53) sont installés aux extrémités opposées de l'élément supérieur de chaque paroi latérale en vue de fixer l'élément supérieur (28) de chaque paroi latérale (14, 16) à la seconde plaque de chacune des parois d'extrémité (12, 18).

11. Cassette selon la revendication 1, dans laquelle des rainures de réception d'articles sont formées par des paires de ladite pluralité d'éléments de compartimentage (40), une partie de l'arrière de chaque rainure ayant un rayon de courbure dans le sens longitudinal de la rainure, qui est généralement le même que le rayon de courbure des articles présents dans la cassette autour de la circonférence des articles.

12. Cassette selon la revendication 1, dans laquelle au moins certains desdits éléments de compartimentage (40) ont une section transversale présentant une inclinaison variant de façon continue pour aider à soutenir une tranche.
